(19) Europäisches Patentamt
European Patent Office
Office européen des brevets

(11) **EP 2 643 930 B1**

(12) **EUROPÄISCHE PATENTSCHRIFT**

(45) Veröffentlichungstag und Bekanntmachung des Hinweises auf die Patenterteilung:
**16.10.2019 Patentblatt 2019/42**

(21) Anmeldenummer: **11801619.5**

(22) Anmeldetag: **22.11.2011**

(51) Int Cl.:
**H03K 7/10** (2006.01)     **H02H 7/10** (2006.01)
**H02J 3/36** (2006.01)     **H01H 33/59** (2006.01)

(86) Internationale Anmeldenummer:
**PCT/EP2011/070674**

(87) Internationale Veröffentlichungsnummer:
**WO 2012/069468 (31.05.2012 Gazette 2012/22)**

(54) **SCHALTUNGSANORDNUNGEN FÜR ELEKTRONISCH GESTEUERTE DC-NETZE**

CIRCUIT ARRANGEMENTS FOR ELECTRONICALLY CONTROLLED DC NETWORKS

CIRCUITERIES POUR RÉSEAUX À COURANT CONTINU À COMMANDE ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.11.2010 DE 102010052136**

(43) Veröffentlichungstag der Anmeldung:
**02.10.2013 Patentblatt 2013/40**

(73) Patentinhaber: **Siemens Aktiengesellschaft
80333 München (DE)**

(72) Erfinder: **MARQUARDT, Rainer
85521 Ottobrunn/Riemerling (DE)**

(56) Entgegenhaltungen:
**DE-A1- 2 311 744     DE-B3-102007 004 528
US-A- 5 793 586     US-A- 5 999 388**

**Beschreibung**

Die Erfindung betrifft eine Vorrichtung zum Schalten in einem Gleichspannungsnetz.

Die Erfindung betrifft ferner ein Verfahren zur Auftrennung eines Leistungsgleichstromnetzes.

Leistungselektronische Systeme in der Energieversorgung - mit sehr hohen erforderlichen Spannungen und Leistungen - gewinnen zunehmend an Bedeutung. Insbesondere für künftige, räumlich ausgedehnte und verzweigte Hochspannungs-Gleichstrom-Netze (engl.: Multiterminal-HVDC) werden Schaltungsanordnungen benötigt, welche die sichere und schnelle Beherrschung von möglichen Störungsfällen sowie geringste Energieverluste im Normalbetrieb ermöglichen. Diese Anforderungen treten insbesondere bei zukünftigen DC-Netzen mit hohen Spannungen und länderübergreifender Fernübertragung auf. Für die erforderlichen sehr hohen Leistungen wurden bisher vorwiegend Stromrichter mit konventionellen Thyristoren und eingeprägtem Gleichstrom eingesetzt (netzgeführte Stromrichter, engl.: Line Commutated Converters, LCC). Netzgeführte Stromrichter erfüllen jedoch nicht die zukünftig steigenden Anforderungen bezüglich hochdynamischer Blindleistungskompensation, Netzspannungsstabilisierung sowie günstiger Einsetzbarkeit von DC-Kabeln (Gleichstromkabeln).

Die angewandten Stromrichtertypen mit eingeprägtem Gleichstrom (engl.: Current Source Converter) eignen sich zudem nicht zur vorteilhaften Realisierung verzweigter HVDC-Netze (engl.: HVDC-Multiterminal-Grids) Als bevorzugte Schaltungsart werden deshalb selbstgeführte Stromrichter mit eingeprägter Gleichspannung eingesetzt. (engl.: Voltage Source Converter, "VSC"). Die inhärenten Nachteile dieser Schaltungsart sind durch neuere Entwicklungen - insbesondere die in DE 10103031A1 "Stromrichterschaltungen mit verteilten Energiespeichern" beschriebenen Maßnahmen - beseitigt worden. Die Voraussetzungen zur Beherrschung von Kurzschlüssen in den angeschlossenen DC-Netzen sind durch den Entfall DC-seitiger Kondensatorbatterien wesentlich günstiger geworden. Trotz der genannten Entwicklungsfortschritte sind die sichere, schnelle und reversible Beherrschung wichtiger Störungsfälle in räumlich ausgedehnten HVDC-Netzen bisher nicht befriedigend gelöst.

Entsprechende, räumlich ausgedehnte, verzweigte HVDC-Netze werden u. a. für ausgedehnte Off-Shore-Windparks und die Nutzung großer Solarkraftwerke in fernen Wüstengebieten künftig dringend benötigt. Insbesondere müssen Kurzschlüsse im HVDC-Netz beherrscht und fehlerbehaftete / kurzgeschlossene Abschnitte des Netzes freigeschaltet werden können.

Günstige mechanische Schalter für die extrem hohen DC-Spannungen, welche hohe Fehlerströme unter Last schalten können, stehen wegen grundlegender physikalischer Probleme nicht zur Verfügung. Auch die technisch erreichbaren Abschaltzeiten und die Schaltüberspannungen mechanischer Schalter sind extrem störend. Entsprechend dem Stand der Technik sind deshalb mechanische Schalter für diese Anwendungen nur als lastlos (stromlos) schaltende Trenner günstig realisierbar.

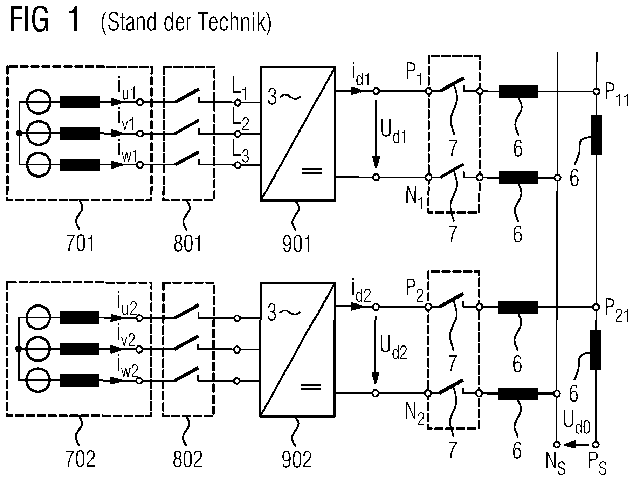

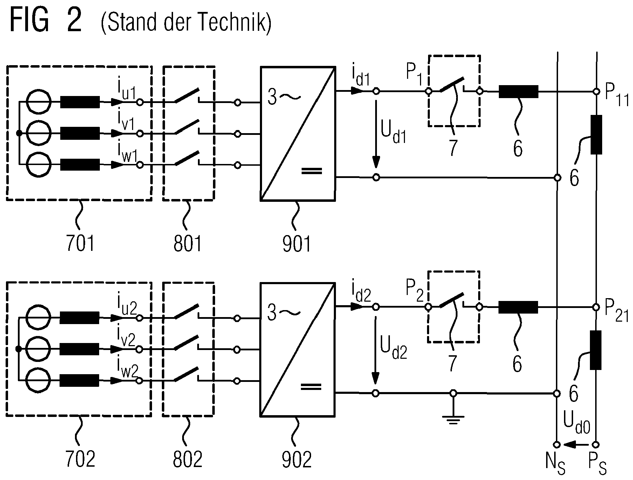

Fig. 1 zeigt - zur weiteren Erläuterung des Standes der Technik - einen Ausschnitt aus einem räumlich ausgedehnten, verzweigten HVDC-Netz. Es zeigt beispielhaft eine Sammelschiene mit den Leitern PS bzw. NS, die gegenüber Erde im Normalbetrieb i. a. eine positive (PS) bzw. negative (NS) Spannung führen. Die Gesamtspannungsdifferenz zwischen den beiden Leitern ist mit (Ud0) bezeichnet. Jedes der angeschlossenen Teilsysteme ist über einen 3-phasigen U-Umrichter mit einem potentialfreien Drehstromnetz verbunden. Die Potentialtrennung erfolgt i. a. mit konventionellen Transformatoren, die für die Netzfrequenz (vorwiegend 50 Hz oder 60 Hz) ausgelegt sind. Dadurch ist es u. a. möglich, das DC-Netz potentialfrei und symmetrisch gegen Erde (Fig. 1) oder potentialgebunden und unsymmetrisch gegen Erde (Fig. 2) zu betreiben.

Es stellen dar:

|      |                                                                                                                                                                                          |
|------|------------------------------------------------------------------------------------------------------------------------------------------------------------------------------------------|
| 6:   | DC-seitige Leitungsinduktivitäten                                                                                                                                                         |
| 7:   | DC-seitige Schalter                                                                                                                                                                       |
| 701: | Ersatzschaltung eines ersten Drehstromnetzes                                                                                                                                              |
| 702: | Ersatzschaltung eines zweiten Drehstromnetzes                                                                                                                                             |
| 801, 802: | Drehstromseitige, mechanische Leistungsschalter                                                                                                                                      |
| 901: | Erster U-Umrichter (VSC), mit den drehstromseitigen Anschlüssen (L1, L2, L3) und den DC-seitigen Anschlüssen (P1, N1), welche über DC-seitige Schalter (7) an die DC-Sammelschiene (PS, NS) führen. |
| 902: | Zweiter U-Umrichter - analog 901 - angeschlossen am zweiten Drehstromnetz, dessen DC-seitige Anschlüsse (P2, N2) über weitere DC- seitige Schalter (7) ebenfalls an die DC-Sammelschiene (PS, NS) führen. |

Durch eine Reihe von Fehlerereignissen im DC-System - insbesondere Leiter / Leiter-Kurzschlüsse oder Erdschlüsse - können die DC- seitigen Ströme unzulässig hohe Werte annehmen. Zur Beherrschung dieser Fehler ist es wünschenswert, dass

- die resultierenden, hohen Ströme bestmöglich begrenzt werden, um Umrichter- und Anlagenschäden durch extreme Temperaturen und magnetische Kraftwirkungen zu vermeiden, und
- defekte Abschnitte des DC-Netzes möglichst schnell stromlos gemacht und vom restlichen DC-Netz getrennt werden.

Entsprechend dem Stand der Technik ist u. a.

aus WO 2008/067786: "Halbleiterschutzelemente zur Beherrschung von DC-seitigen Kurzschlüssen bei Spannungszwischenkreisumrichtern" bekannt, dass ein Öffnen der drehstromseitigen Leistungsschalter (801, 802) zwecks Begrenzung DC-seitiger Fehlerströme ermöglicht, jedoch sehr nachteilig ist. Die resultierenden hohen Ströme bzw. die langen Abschaltzeiten zwingen zu weiteren, aufwändigen Schutzmaßnahmen für die Halbleiter der U-Umrichter (901, 902) - wie in o. a. Patentschrift dargelegt ist. Des weiteren wird die Energieübertragung für eine störend lange Zeit unterbrochen. Es ist demnach wünschenswert, dass die drehstromseitigen Ströme (iu, iv, iw) möglichst wenig gestört werden und eine Auslösung der drehstromseitigen Leistungsschalter (801, 802) vermieden wird. Ein weiteres wichtiges Ziel ist es, den Leistungsfluss in den nicht fehlerbehafteten Teilen des HVDC-Netzes aufrechtzuerhalten oder so schnell wie möglich wiederherzustellen. Ein Auslösen und erneutes Einschalten der drehstromseitigen Leistungsschalter (801, 802) würde jedoch bereits sehr störende Unterbrechungszeiten von i. a. deutlich über 200 ms verursachen. Ein direkter Ersatz mechanischer Leistungsschalter durch elektronische Leistungsschalter an der DC-Seite ist bekannt und ermöglicht wesentlich kleinere Schaltzeiten (siehe u. a. US005999388A: "Method and apparatus for limiting current in a direct voltage network of a power transmission system"). (Aus dieser Schrift US005999388A sind die Merkmale des Oberbegriffs des Patentanspruchs 1 bekannt.)

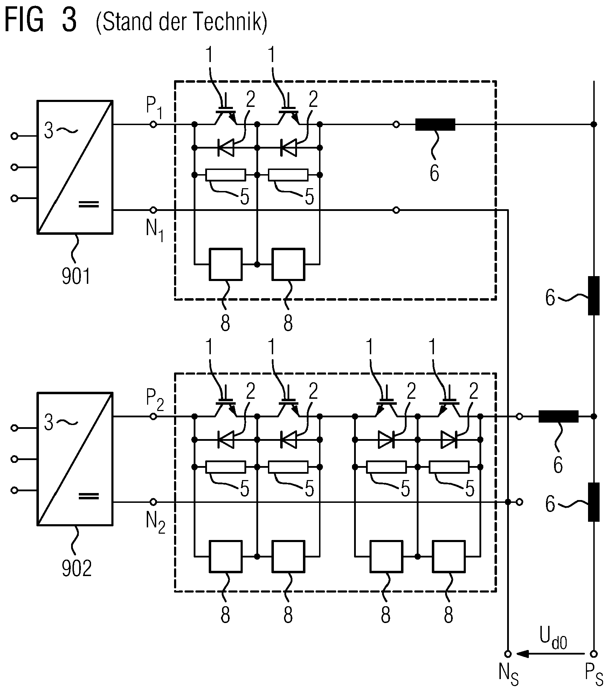

Eine derartige Anordnung ist zwecks weiterer Erläuterung in Fig. 3 dargestellt.

Es werden zu diesem Zweck

- Abschaltbare Leistungshalbleiter (1), i. a. in Form von IGBT-Transistoren
- Antiparallele Dioden (2) bzw. weitere abschaltbare Leistungshalbleiter
- Maßnahmen zur gleichmäßigen Spannungsaufteilung der Halbleiter, i. a. hochohmige Beschaltungswiderstände (5)
- Überspannungsbegrenzer mit hohem Energieaufnahmevermögen (8), i. a. in Form von Varistoren benötigt.

Im vorliegenden Anwendungsbereich - der durch sehr hohe Spannungen und Leistungen sowie weitgehenden Dauerbetrieb gekennzeichnet ist - sind die Nachteile einer solchen Lösung jedoch sehr schwerwiegend.

Diese sind:

- Die hohe Anzahl seriengeschalteter Halbleiter (1, 2);
- die erforderliche, forcierte Kühlung der Halbleiter, da diese im Dauerbetrieb hohe Durchlassverluste erzeugen;
- das Erfordernis einer elektronischen Gate-Ansteuerung dieser Halbleiter auf hohem Potential gegen Erde und die sichere Bereitstellung von deren Ansteuerenergie auf diesem hohen Potential;
- der hohe Aufwand, welcher sich auch bei Realisierung mehrerer Schalter an einem Ort nicht reduzieren lässt;
- die beträchtliche Verlustleistung im Durchlasszustand der Halbleiter, welcher dem normalen Dauerbetrieb entspricht - wodurch die laufenden Betriebskosten der Anlage erhöht sind;
- beim Abschaltvorgang müssen zusätzliche Überspannungs schutzelemente (8) an den einzelnen Halbleiterschaltern die erheblichen magnetischen Energien der abgeschalteten Netzabschnitte des DC-Netzes absorbieren.

Letztgenannter Punkt ist sehr nachteilig, weil sich aufgrund der Vielzahl der benötigten Überspannungsschutzelemente (8), i. a. nur einfache Varistoren mit nicht idealer Begrenzer-Kennlinie - einsetzen lassen. Die Anzahl benötigter, seriengeschalteter Halbleiter steigt dadurch nochmals an.

Eine weitere Erhöhung des Aufwandes und der Durchlassverluste tritt auf, wenn der elektronische Schalter in beiden Stromrichtungen abschaltfähig sein muss (siehe Fig. 3, unterer Teil). Diese Forderung tritt auf, wenn der elektronische Schalter an beliebigen Orten eines allgemeinen DC-Netzes einsetzbar sein soll.

Aus der Schrift DE 23 11 744 A1 ist eine Anordnung zur Abschaltung von Gleichströmen mittels eines Hybridschalters bekannt, wobei zwischen dem Hybridschalter und einem Verbraucher zwei parallelgeschaltete RC-Querstromglieder angeordnet sind, deren aufgeladene Kondensatoren zur Bildung einer löschenden Umschwingspannung am Hybridschalter schaltbar sind. Aufgabe der Erfindung ist es, diese Nachteile zu vermeiden und günstig realisierbare Schaltungsanordnungen für DC-Schalter mit folgenden wesentlichen Eigenschaften zu ermöglichen:

- Die erreichbaren Abschaltzeiten sind sehr kurz, so dass drehstromseitige Schalter nicht ausgelöst werden müssen und der Energiefluss im DC-Netz nicht nennenswert gestört wird;
- Die Halbleiter benötigen keine forcierte Kühlung, da sie im normalen Dauerbetrieb keine Durchlassverlustleistung aufweisen;
- Die Ansteuerenergie der Halbleiter kann aus der an den Halbleitern selbst anliegenden Sperrspannung gewonnen werden;
- Die Schaltüberspannungen lassen sich durch die Dimensionierung der Komponenten auf günstige Werte festlegen und begrenzen, welche eine wirtschaftliche Bemessung der Isolationen im DC-Netz ermöglichen;
- Im typischen Anwendungsfall der Realisierung mehrerer Schalter an einem Ort lässt sich der Schaltungsaufwand durch die Nutzung gemeinsamer Komponenten weiter reduzieren.

Diese Aufgabe wird durch eine Vorrichtung und durch ein Verfahren nach den unabhängigen Patentansprüchen gelöst.

Die Erfindung löst diese Aufgaben durch eine Vorrichtung zum Schalten von Gleichströmen in einem Gleichspannungsnetz mit zwei gegensinnig in Reihe geschalteten Hybridschaltern, welche jeweils eine Parallelschaltung eines ungesteuerten stromrichtungsabhängigen Schalters und eines steuerbaren Schalters aufweisen, wobei der innere Verbindungspunkt zwischen den Hybridschaltern einen dritten Anschluss ausbildet und die zwei gegensinnig in Reihe geschalteten Hybridschalter mit einem ersten und einem zweiten Anschluss in eine erste Leitung des Gleichspannungsnetzes einfügbar sind; mit zwei polarisierten Dämpfungsgliedern, die zur Energieaufnahme in nur einer Polarität der anliegenden Klemmenspannung eingerichtet sind, wobei das erste polarisierte Dämpfungsglied an den ersten Anschluss der in Reihe geschalteten Hybridschalter angeschlossen ist und mit einer zweiten Leitung des Gleichspannungsnetzes und/oder einem Erdpotential verbindbar ist und das zweite polarisierte Dämpfungsglied an den zweiten Anschluss der in Reihe geschalteten Hybridschalters angeschlossen ist und mit der zweiten Leitung des Gleichspannungsnetzes und/oder dem Erdpotential verbindbar ist; und mit einem Stromimpulsgenerator, der - auf einen Steuerbefehl hin - zum Erzeugen eines über den dritten Anschluss und die polarisierten Dämpfungsglieder führenden unipolaren Stromimpuls eingerichtet ist, so dass die Stromrichtung in einem der Hybridschalter kurzzeitig umkehrbar ist.

Die genannten Subsysteme, also der Hybridschalter, das Dämpfungsglied und der Stromimpulsgenerator, ermöglichen in Verbindung mit den im folgenden beschriebenen, erfindungsgemäßen Schaltungsanordnungen die Realisierung einpoliger und mehrpoliger DC-Schalter mit den genannten, vorteilhaften Eigenschaften.

Eine weitere, kennzeichnende Eigenschaft aller erfindungsgemäßen Subsysteme ist ihre Ausführbarkeit als Zweipol. Dies ermöglicht nicht nur eine reduzierte Anzahl äußerer Anschlüsse ("Klemmen") sondern eine freizügige Kaskadierbarkeit, d.h.: jedes Subsystem höherer Spannung kann jederzeit durch eine Reihenschaltung einer beliebigen Anzahl von Subsystemen kleiner Spannung gebildet werden. Des weiteren wird durch dieses erfindungsgemäße Vorgehen ein konsistentes Redundanzkonzept ermöglicht, welches die sichere Funktion des DC-Schalters auch bei Defekten einzelner oder mehrerer Subsysteme ermöglicht.

Einen weiteren technischen Vorteil stellt in diesem Zusammenhang die Tatsache dar, dass die erfindungsgemäßen Subsysteme keine Halbleiter mit fehlerkritischen, nicht stoßstromfesten Kontaktleitungen - wie z. B. Bonddrähte bei IGBT-Transistoren - benötigen. Weil die erfindungsgemäßen Schaltungsanordnungen ausschließlich mit Halbleiterdioden und Thyristoren als Halbleitern realisiert werden können, sind hingegen Bauelemente mit stoßstromfester Druckkontaktierung einsetzbar.

Insbesondere ermöglicht die beliebige Serienschaltbarkeit aller erfindungsgemäßen Subsysteme eine freie Wahl der Nennspannung der eingesetzten Bauelemente unabhängig von der vorgegebenen Spannung des DC-Netzes. Ein Aspekt sind diesbezüglich wirtschaftliche Gründe und die marktübliche Verfügbarkeit der Bauelemente. Ein technisch wichtigerer Freiheitsgrad, welcher aus dieser Eigenschaft resultiert, ist jedoch die Optimierung der Schaltgeschwindigkeit der realisierbaren DC-Schalter.

Für die erfindungsgemäßen Schaltungsanordnungen ermöglicht dieser erläuterte Freiheitsgrad der Zweipoligkeit und der beliebigen Kaskadierbarkeit die Erzielung einer hohen, geforderten Schaltgeschwindigkeit. Wie im folgenden noch erläutert werden wird, können die hier relevanten Bauelemente durch Wahl einer niedrigeren Nennspannung bzgl. ihrer Schaltgeschwindigkeit deutlich verbessert werden. Dies gilt z.B. für Vakuumschaltröhren (aufgrund kürzerer, mechanischer Betätigungswege und geringerer Massen) sowie bekanntlich auch für Halbleiterdioden und Thyristoren hinsichtlich ihrer Sperrverzugszeiten und /oder Freiwerdezeiten.

Die Erfindung löst diese Aufgabe auch durch ein Verfahren zur Auftrennung eines Leistungsgleichstromnetzes mit den Schritten: Erzeugen eines Strompulses, der in einem Hybridschalter, welcher eine Parallelschaltung eines ungesteuerten stromrichtungsabhängigen Schalters und eines steuerbaren Schalters aufweist, auf der in Stromflussrichtung liegenden Seite kurzzeitig eine Stromumkehr hervorruft, so dass der steuerbare Schalter des Hybridschalters während der Stromumkehr verlöschen kann und so die Stromzufuhr zwischen einer Quelle und einem Verbraucher trennt, wobei ein polarisiertes Dämpfungsglied auf der in Stromflussrichtung liegenden Seite die verpolte Spannung auf der in Stromflussrichtung liegenden Seite dämpft und dadurch die verbraucherseitige Leitungsinduktivität entregt, wobei ein Stromimpulsgenerator die überhöhte Spannung auf der entgegen der Stromflussrichtung liegenden Seite dämpft.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkenden Bauteile verweisen und wobei

| | |
|---|---|
| Figuren 1-3 | jeweils einen Ausschnitt aus einem räumlich ausgedehnten verzweigten Gleichspannungsnetz gemäß dem Stand der Technik, |
| Figuren 4-6 | prinzipielle DC-Schalteranordnungen, wobei die Schalter selbst schematisch durch mechanische Schalter symbolisiert sind, |
| Figuren 8-12 | Ausführungsbeispiele der erfindungsgemäßen Vorrichtung, |

Figuren 13-19 Ausführungsbeispiele für einen Hybridschalter, ein polarisiertes Dämpfungsglied beziehungsweise einem Stromimpulsgenerator und

Figuren 20-21 Lösungen für die Steuerbarkeit der Stromaufteilung zeigen.

Die Figuren 1 bis 3 wurden als zum Stand der Technik gehörig bereits in der Beschreibungseinleitung beschrieben.

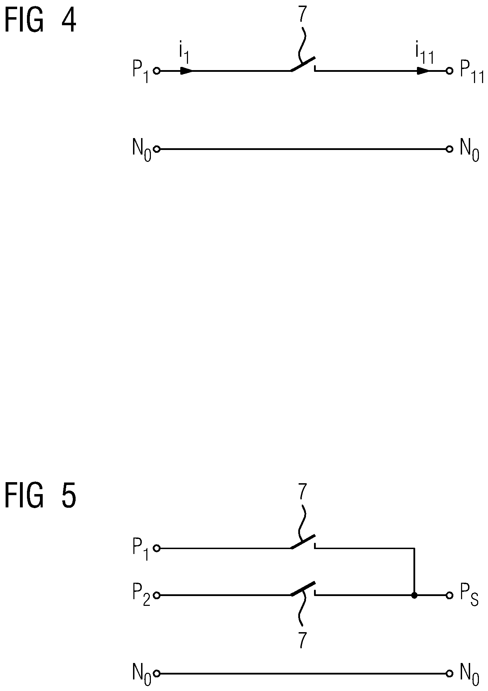

Figur 4 zeigt einen einpoligen DC-Schalter, welcher in einem einfachen, i. a. einseitig geerdeten DC-Netz (Gleichspannungs- oder Gleichstromnetz) zur Trennung der Plusleitung (P1 gegen P11) eingesetzt wird. Diese Anordnung kann ausreichend sein, falls die Minusleitung (N0) eindeutig geerdet ist.

Figur 5 zeigt eine Anordnung analog Fig. 4 - jedoch mit mehreren (hier beispielhaft: zwei) DC-Schaltern - welche auf eine gemeinsame Sammelschiene(PS)führen

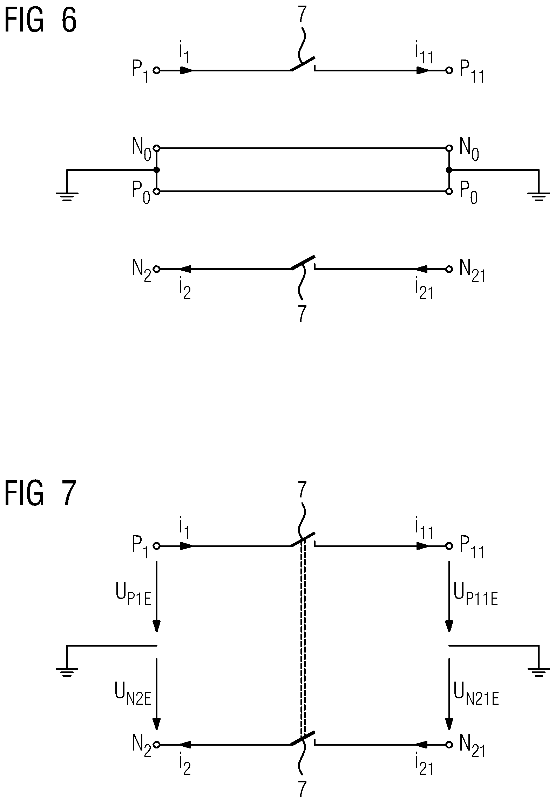

Figur 6 zeigt eine Anordnung analog Fig. 4, der jedoch eine weitere DC-Leitung mit negativer Polarität und zugehörigem Schalter hinzugefügt wurde. Die DC-Spannungen (UP1 gegen N0) der positiven Leiter und (UN2 gegen N0) der negativen Leiter - jeweils gegen die gemeinsame, geerdete Leitung gemessen - werden hier i. a. betragsmäßig gleich groß gewählt. Die Lastströme der positiven Leitung (i1) und der negativen Leitung (i2) können jedoch bereits im Normalbetrieb unterschiedlich sein. Die beiden Schalter (7) sollen deshalb i. a. einzeln, d.h.: unabhängig voneinander abschaltbar sein.

Figur 7 zeigt eine Anordnung analog Fig. 6 jedoch ohne stromtragfähige Nullleitung. Durch geeignete Erdungsmaßnahmen - i. a. eine hochohmige Potentialanbindung durch Widerstände - wird sichergestellt, dass die Spannungen der Plusleitung (UP1E) und der Minusleitung (UN2E) gegen Erde symmetrisch aufgeteilt sind. Im Falle von Erdschlüssen kann sich diese Potentialverteilung jedoch verschieben, wodurch die Isolation unerwünscht hoch beansprucht wird. In einem derartigen, symmetrisch betriebenen, erdfreien DC-Netz wird bei Störungsfällen i. a. eine zweipolige Abschaltung gefordert, wobei die Betätigung der Schalter (7) gemeinsam erfolgen kann. Zwecks näherer Erläuterung der Erfindung sei zunächst die Realisierung eines einpoligen Schalters dargelegt (siehe Fig. 4).

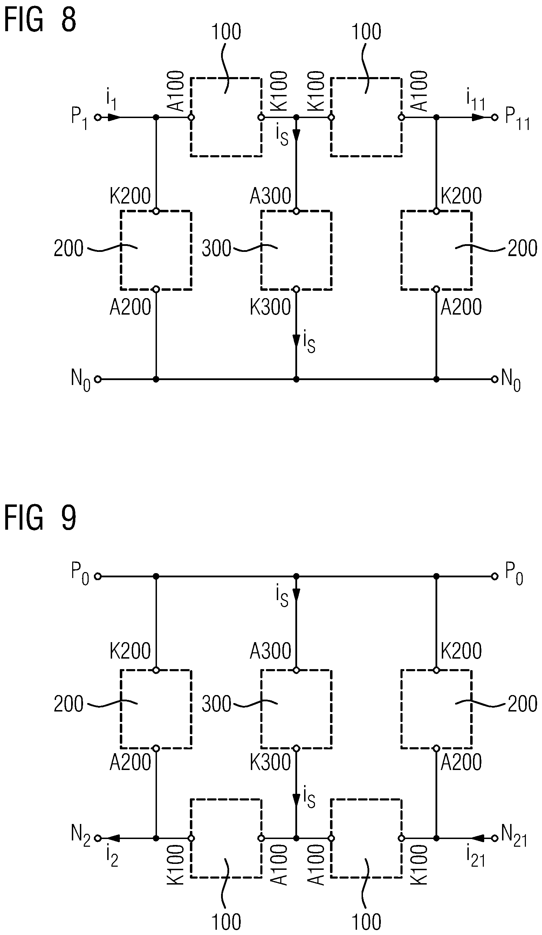

Eine entsprechende, erfindungsgemäße Realisierung ist in Fig. 8 dargestellt. Grundsätzlich enthalten erfindungsgemäße Schaltungsanordnungen zur Realisierung einpoliger oder mehrpoliger DC-Schalter folgende Subsysteme, welche durch folgende Eigenschaften gekennzeichnet sind:

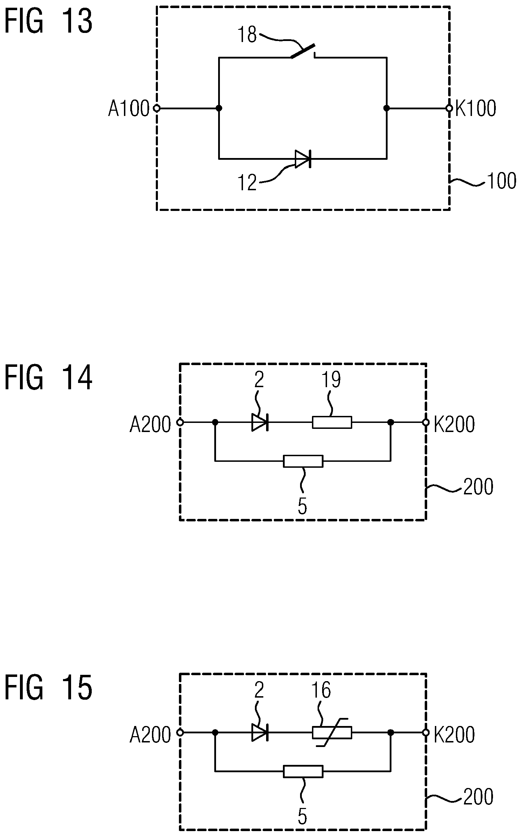

a) Schaltelemente, im folgenden Hybridschalter (100) genannt, welche intern eine Parallelschaltung aus ungesteuerten Schaltern (12) und steuerbaren Schaltern (18) aufweisen. Dabei ist der ungesteuerte Schalter (12) vorzugsweise als wenigstens eine Halbleiterdiode und der gesteuerte Schalter (18) vorzugsweise als wenigstens eine Vakuumschaltröhre ausgeführt (Fig. 13).

b) Polarisierte Dämpfungsglieder (200), welche in einer Polarität der anliegenden Klemmenspannung dissipativ Energie aufnehmen und sich in der entgegengesetzten Polarität der anliegenden Klemmenspannung einem Stromfluss und folglich einem Energieumsatz entgegenstellen. Diese polarisierten Dämpfungsglieder sind vorzugsweise als Serienschaltung von linearen (19) oder nichtlinearen (15) Widerständen und Halbleiterdioden (2) realisiert (Fig. 14, Fig. 15).

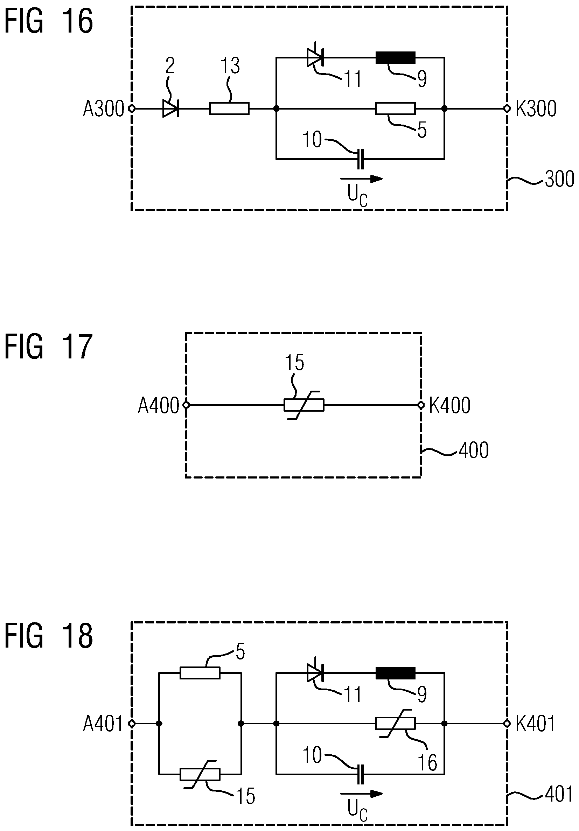

c) Stromimpulsgeneratoren (300), welche auf einen externen Steuerbefehl hin einen unipolaren Stromimpuls erzeugen. Diese enthalten zumindest einen kapazitiven Energiespeicher (10), welcher aus der an den Klemmen anliegenden DC-Spannung geladen wird und der in Kombination mit weiteren Komponenten (2, 13) einen Schaltungszweig zur Begrenzung von Überspannungen bildet (Fig. 16).

Fig. 9 zeigt eine erfindungsgemäße Anordnung analog Fig. 8 - jedoch mit umgekehrter Polarität aller Subsysteme. Eine derartige Variante ist zur Realisierung eines DC-Schalters in einem DC-Netz umgekehrter Polarität geeignet. Dies entspricht prinzipiell dem unteren Schalter (7) in Fig. 6, welcher die Punkte (N2) und (N21) trennt. Werden die Punkte (P0) aus Fig. 9 mit den Punkten (N0) aus Fig. 8 elektrisch leitend verbunden, resultiert eine Anordnung analog der in Fig. 6 bereits beschriebenen.

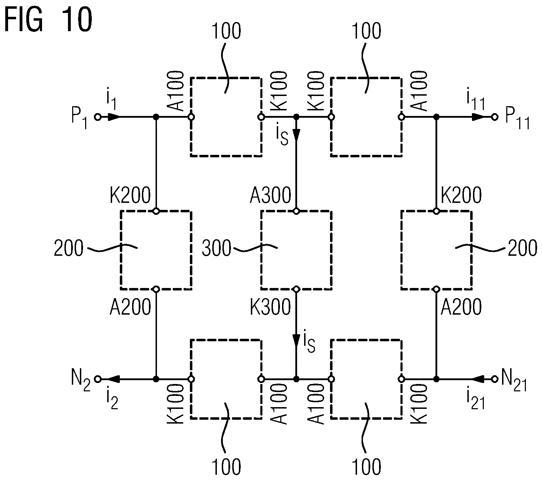

Fig. 10 zeigt eine erfindungsgemäße Anordnung, welche die Funktion des zweipoligen DC-Schalters nach Fig. 7 realisiert. Vorteilhaft ist, dass sowohl die polarisierten Dämpfungsglieder (200) als auch der Stromimpulsgenerator (300) nur einmal erforderlich sind.

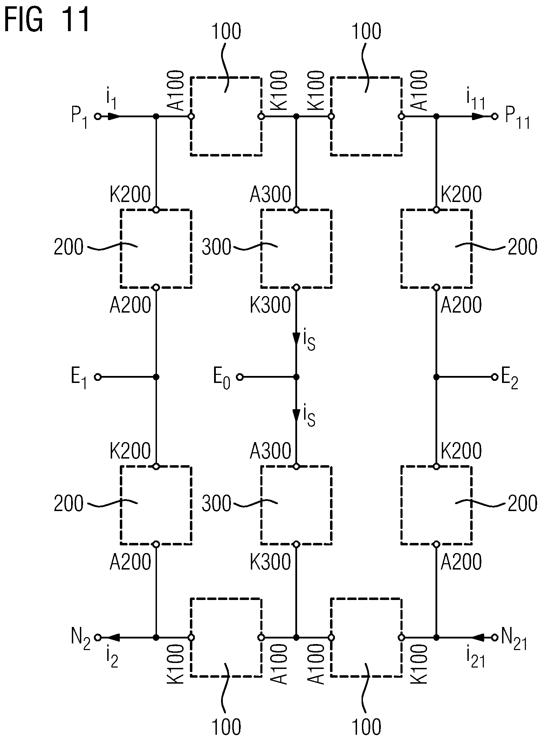

Fig. 11 zeigt eine erfindungsgemäße Anordnung analog Fig. 10. Im Unterschied zu Fig. 10 sind die Stromimpulsgeneratoren (300) und die polarisierten Dämpfungsglieder (200) dergestalt aufgeteilt, dass an ihren Verbindungspunkten (E) eine Möglichkeit für eine Erdung besteht. Dies kann je nach Erdungskonzept des DC-Netzes sinnvoll sein. Insbesondere ermöglicht die Erdung des Verbindungspunktes (E0), dass in einem potentialfrei, erdsymmetrisch betriebenen DC-Netz (Fig. 7 u. zug. Erläuterung) die unerwünschte Potentialverschiebung bei Erdschlussfehlern durch die überspannungsbegrenzende Eigenschaft der Subsysteme (300) bzw. auch (400) - falls vorhanden - begrenzt werden kann. Dadurch kann erreicht werden, dass die Isolationen der Komponenten des DC-Netzes geringer beansprucht werden.

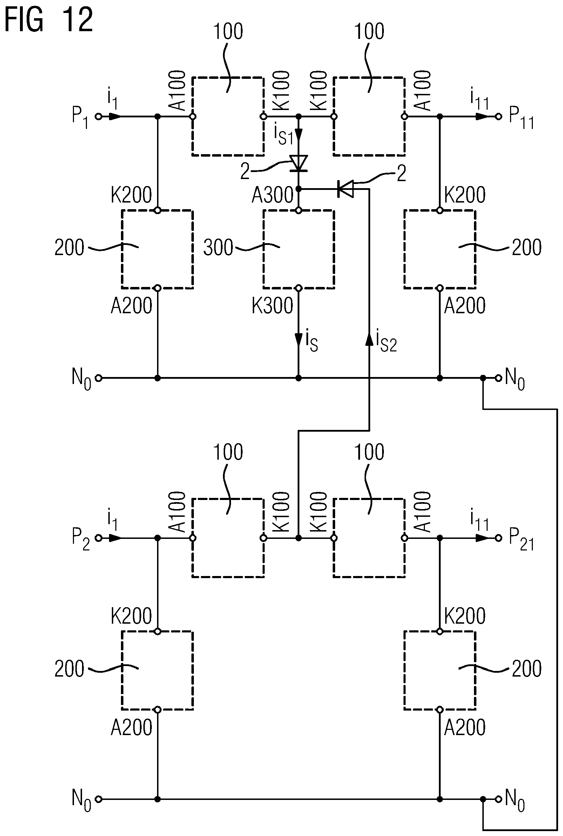

Fig. 12 zeigt eine erfindungsgemäße Schaltungsanordnung, welche die Funktion der in Fig. 5 dargestellten mehrfachen Schalter (7) an einer gemeinsamen Sammelschiene realisiert. Vorteilhaft ist, dass der Stromimpulsgenerator (300) nur einmal erforderlich ist, weil dessen Stromimpuls (iS) durch die Dioden (2) verteilt werden kann. Anhand von Fig. 8 sei, zwecks weiterer Erläuterung der Erfindung, im folgenden nochmals die Realisierung eines einpoligen Schalters erläutert. Ein derartiger DC-Schalter dient dazu unter Laststrom schnell abzuschalten und letztlich eine Trennung der DC-Leitungen zwischen zwei Netzabschnitten des DC-Netzes zu ermöglichen. Die anschließend - für eventuelle Reparaturarbeiten an der DC-Leitung - erforderliche sichere Trennung und Erdung ist nicht Gegenstand der vorliegenden Erfindung. Geeignete Geräte für diesen Zweck sind bekannt und technisch gut realisierbar, weil diese Geräte erst nachträglich - im bereits stromlosen Zustand der DC-Leitung - sowie ohne besondere Anforderungen an die Schaltgeschwindigkeit arbeiten müssen.

Gemäß der Erfindung sind zwei Hybridschalter (100) gegensinnig in Reihe zwischen die zu trennenden Netzabschnitte zu schalten. Am Verbindungspunkt der beiden Hybridschalter (100) ist ein Stromimpulsgenerator (300) angeschlossen. Jeder der zu trennenden Netzabschnitte ist des weiteren mit je einem polarisierten Dämpfungsglied (200) beschaltet. Eine derartige Konfiguration ermöglicht es nun, dass ein vom Stromimpulsgenerator (300) erzeugter, hoher Stromimpuls (iS) mit der eingezeichneten technischen Stromrichtung (iS > 0) parallel aufgeteilt über beide Hybridschalter (100) und die polarisierten Dämpfungsglieder (200) fließt. Die gesteuerten Schalter (18) der Hybridschalter (100) waren i.a. vor diesem Zeitpunkt eingeschaltet um die Energieverluste (Durchlass-Spannungsabfall) im normalen Zustand der Stromübertragung zu minimieren. Es ist grundsätzlich jedoch auch möglich, dass einer der Schalter (18) - hier der linke - nicht eingeschaltet wurde, weil der parallele, ungesteuerte Schalter (12) ohnehin den Strom leiten kann. Bezüglich der Energieverluste im normalen Dauerbetrieb ist dies jedoch nicht vorteilhaft, da der Durchlass-Spannungsabfall der Schalter (18) i. a. um Zehnerpotenzen unter dem der ungesteuerten Schalter (12) liegt. Dies gilt insbesondere, falls die Schalter (18) als Vakuumschaltröhren und die ungesteuerten Schalter (12) als Halbleiterdioden ausgeführt sind. Während des Stromimpulses (iS) - bzw. je nach Schalterart (18) auch bereits zeitlich davor - werden die gesteuerten Schalter (18) geöffnet. Der Strom in einem der beiden gesteuerten Schalter (18) wird bei genügend hohem Stromimpuls (iS) zu Null werden, so dass dieser leistungslos sperrt. Im vorliegenden Beispiel mit positivem Strom (i1 > 0) wird dies der rechte Schalter in Fig. 8 sein. Der zugehörige Laststrom (i11) im zugehörigen DC-Netzabschnitt wird aufgrund der hohen, in der Leistungsinduktivität (6) gespeicherten Energie momentan über das polarisierte Dämpfungsglied (200) weiterfließen und dort gegen die negative Spannung des Dämpfungsgliedes abklingen.

Der zugehörige Laststrom im anderen DC-Netzabschnitt (in diesem Beispiel mit i1 > 0: Der linke Teil (P1, i1)) wird aus den gleichen Gründen momentan weiterfließen - jedoch über den Hybridschalter in den Stromimpulsgenerator (300) und gegen die Klemmen-Spannung des Stromimpulsgenerators abklingen. Die erfindungsgemäßen Ausführungen des Stromimpulsgenerators (300, 500) weisen diesbezüglich die bereits erläuterte Eigenschaft auf, durch den internen Schaltungszweig (10, 2, 13) die bei Schaltvorgängen resultierenden Überspannungen zu begrenzen.

Ein weiterer Vorteil der erfindungsgemäßen Schaltungsanordnungen besteht darin, dass sowohl der Stromimpulsgenerator (300), als auch ein optionaler zusätzlicher Überspannungsbegrenzer (400) für eine gegebene Anordnung von mehreren DC-Schaltern an einem Ort nur einmal benötigt werden. Dies entspricht einer vorteilhaften Mehrfachnutzung. Diese Tatsache, wird im Folgenden - an Hand der Beschreibung mehrpoliger Schalter - noch näher erläutert.

Zur abschließenden Erläuterung der Erfindung ist es nun erforderlich im folgenden die innere Schaltung der Subsysteme, ihre innere Funktionsweise sowie vorteilhafte Schaltungsvarianten darzulegen:

Fig. 13 zeigt die innere Schaltung eines erfindungsgemäßen Hybridschalters (100). Er enthält eine Parallelschaltung eines ungesteuerten Schalters (12) und eines steuerbaren Schalters (18). Des weiteren ist eine Ausführung mit interner Serienschaltung dieser Elemente selbstverständlich möglich. Eine beliebige Anzahl von Hybridschaltern (100) ist grundsätzlich ebenfalls als Reihenschaltung einsetzbar um einen Hybridschalter beliebig hoher Spannung zu realisieren. Lediglich einfache, bekannte Maßnahmen zur gleichmäßigen Spannungsaufteilung - i.a. hochohmige Beschaltungswiderstände (5) - sind zu diesem Zweck vorzusehen (siehe die Erläuterungen zu Fig. 3). Eine bevorzugte Ausführungsform der Erfindung besteht darin, für die ungesteuerten Schalter (12) Halbleiterdioden und für die gesteuerten Schalter (18) Vakuumschaltröhren einzusetzen. Grundsätzlich sind auch andere Schalterarten sowie Halbleiterschalter einsetzbar. Mit Vakuumschaltröhren mittlerer Schaltspannung lassen sich aufgrund der sehr kurzen Betätigungswege und der geringen, bewegten Massen sehr kurze Abschaltverzögerungszeiten erzielen. Zu diesem Zweck ist es als vorteilhaft bekannt, die benötigte mechanische Energie zur Betätigung des Schalters aus einer vorgespannten Feder, einem Druckluftspeicher oder einem hydraulischen Speicher zu entnehmen.

Fig. 14 zeigt die innere Schaltung eines polarisierten Dämpfungsgliedes (200). Es enthält in seiner einfachsten Ausführungsform einen Dämpfungswiderstand (19) und eine Halbleiterdiode (2). Maßnahmen zur gleichmäßigen Spannungsaufteilung der Halbleiterdioden bei Serienschaltung sind in bekannter Form; z.B. durch hochohmige Beschaltungswiderstände (5) zusätzlich anwendbar.

Fig. 15 zeigt eine mögliche Variante von Fig. 14, bei der der Dämpfungswiderstand (19) durch einen Varistor (16) ersetzt ist. Dies hat den Vorteil, dass der Strom in einem abgetrennten Abschnitt des DC-Netzes schneller abklingt, als dies bei Einhaltung einer vorgegebenen , geringen Überspannung, mittels eines linearen (ohmschen) Dämpfungswiderstandes erfolgt.

Fig. 16 zeigt eine bevorzugte innere Schaltung des Stromimpulsgenerators (300) . Sie enthält in erfindungsgemäßer Anordnung folgende Elemente:

- Sperrdiode (2)
- Reihenwiderstand (13)
- Gesteuerter Halbleiterschalter (11), i.a. vorzugsweise als Thyristor
- Kapazitiver Energiespeicher (10)
- Induktivität (9)
- Hochohmiger Beschaltungswiderstand (5)

Der kapazitive Energiespeicher (10) wird selbsttätig über die Elemente (2) und (13) auf die DC-Spannung am entsprechenden Anschlusspunkt des DC-Netzes aufgeladen. Gleichzeitig ergibt der Strompfad über die Elemente (2), (13) und (10) in vorteilhafter Weise eine Überspannungsbedämpfung am entsprechenden Anschlusspunkt des DC-Netzes.

Soll ein Schaltvorgang der Hybridschalter (100) ausgelöst werden, wird der gesteuerte Halbleiterschalter (11) eingeschaltet. Im folgenden wird zwecks einfacher Erläuterung von einem Thyristor ausgegangen, welcher gezündet wird. In der ersten Viertelschwingung des aus (9) und (10) gebildeten Schwingungskreises wird die Energie des kapazitiven Energiespeichers (10) in die magnetische Energie der Induktivität (9) umgewandelt. Diese erste Viertelschwingung verläuft prinzipiell ungedämpft und kann zeitlich sehr kurz gewählt werden. Ihre Dauer beträgt bekanntlich

$$t_1 = \Pi / 2 * \sqrt{LC}$$

wo L die Induktivität von (9) und C die Kapazität von (10) bezeichnen.

Die Stromamplitude des resultierenden Stromes in (9) beträgt

$$i(t_1) = U_c(0) * \sqrt{C / L}$$

wobei $U_c(0)$ die vorher bestehende Ladespannung des kapazitiven Energiespeichers (10) bezeichnet.

Gemäß der Erfindung ist es vorteilhaft und technisch gut erreichbar, dass die Zeit $(t_1)$ sehr kurz und die Stromamplitude $i(t_1)$ hoch ist. Beide Ziele werden im wesentlichen durch die Eigenschaften des Schalters (11) begrenzt. Im Falle eines Thyristors sind dies die zulässige Stromsteilheit und die zulässige Stoßstromamplitude. Es ist vorteilhaft, dass der zugehörige Stromkreis, in dem die erste Viertelschwingung erfolgt, nur in einem räumlich engen, definierten Kreis über die ebenfalls gut definierbaren Elemente (9, 10, 11) und nicht über das DC-Netz führt. Falls der Grund für den notwendigen Schaltvorgang ein DC-seitiger Kurzschluss ist, wird es günstig sein diesen Fehlerfall sowohl durch das Überschreiten gemessener DC-Ströme als auch durch das Überschreiten DC-seitiger Stromsteilheiten möglichst schnell zu erkennen, um ohne große Verzögerungen den Thyristor (11) zu zünden. Diese und andere Methoden der schnellen Fehlererkennung sind jedoch prinzipiell bekannt und nicht Gegenstand der vorliegenden Erfindung.

Für den Einsatz von Vakuumschaltröhren als gesteuerte Schalter (18) ist es günstig und möglich, diese bereits gleichzeitig mit oder kurz vor der Zündung von (11) mechanisch zu betätigen. Dies ermöglicht es, deren mechanische Abschaltverzögerungszeit parallel zu der Vorbereitung der elektrischen Abschaltung ablaufen zu lassen.

Nach dem Zeitpunkt $(t_1)$ wird die Spannung des kapazitiven Energiespeichers (10) negative Werte annehmen und der Strom in (9) und (11) wird abnehmen bis er im Zeitpunkt $(t_2)$ zu Null wird. Diese weitere Viertelschwingung verläuft in den erfindungsgemäßen Schaltungsanordnungen in Folge des Reihenwiderstandes (13) und der polarisierten Dämpfungsglieder (200) in gedämpfter Form. Es ist dadurch in vorteilhafter Weise möglich, die wirksame Dauer des erzeugten Stromimpulses $(i_s)$ sowie die Schonzeit des Thyristors (11) wesentlich größer, als die - andernfalls durch den Schwingkreis (9, 10) - resultierenden Werte zu machen. Des weiteren ist es in der erfindungsgemäßen Anordnung möglich, den Reihenwiderstand (13) so groß zu bemessen, dass auch bei beliebigen äußeren Kurzschlüssen (außerhalb des Stromimpulsgenerators (300)) der Thyristor (11) nach dem Ende des Stromimpulses sicher verlöscht.

Zu diesem Zweck genügt es , für den Reihenwiderstand (13) eine Dimensionierung entsprechend

$$R_{13} = \sqrt{L / C}$$

zu wählen. Unabhängig davon kann die gewünschte Stromamplitude, welche der Stromimpulsgenerator (300) erzeugt, wie bereits erläutert, durch die Wahl seiner internen Komponenten (9, 10) sowie durch die Bemessung der Komponenten (19, 16) in den polarisierten Dämpfungsgliedern (200, 201) wunschgemäß eingestellt werden.

Ein weiterer wichtiger Parameter ist die Größe der durch die Schaltvorgänge im DC-Netz entstehenden Schaltüberspannungen. Es ist erwünscht, diese gut definiert vorgeben zu können und die Größe der Schaltüberspannungen nur so groß zu wählen, dass das Abklingen des DC-Stromes in abgetrennten DC-Netzabschnitten genügend schnell erfolgt. Die erfindungsgemäßen Schaltungsanordnungen ermöglichen dies bereits prinzipbedingt:

- Die negativen Schaltüberspannungen werden durch entsprechende Bemessung der polarisierten Dämpfungsglieder (200) begrenzt;

- Die positiven Schaltüberspannungen werden durch die Komponenten (2, 13, 10) der Stromimpulsgeneratoren (300) begrenzt.

Letztgenannter Wert kann jedoch nicht unabhängig von der Bemessung des kapazitiven Energiespeichers (10) gewählt werden. Aus diesem Grunde ist optional eine weitere Maßnahme in Form eines zusätzlichen Überspannungsbegrenzers (400) anwendbar. Es ist sinnvoll, diesen direkt parallel zu (300) oder kathodenseitig an dessen Diode (2) anzuschließen.

Figuren 17 und 18 zeigen mögliche Ausführungsformen. Figur 17 stellt die einfache Möglichkeit des Einsatzes eines Varistors (15) dar, welcher in Kombination mit bereits erläuterten Komponenten (2, 13, 10) bereits eine wesentlich bessere Überspannungsbegrenzung als bei alleiniger Verwendung ermöglicht.

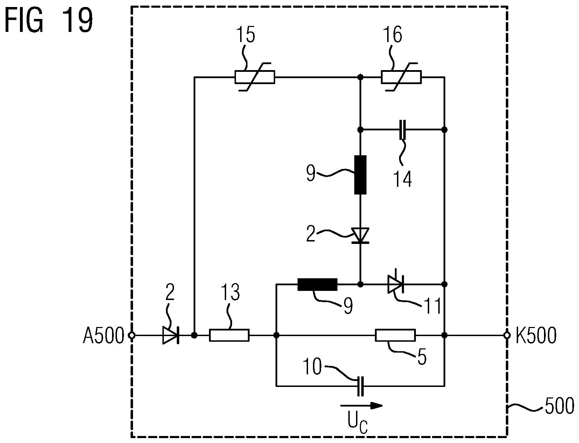

Figuren 18 und 19 zeigen jeweils eine weitere Ausführungsform, welche eine extrem reduzierte, besonders eng tolerierte Überspannungsbegrenzung ermöglicht. Diese ist geeignet, höchste Anforderungen an die Überspannungsbegrenzung zu erfüllen, welche mit bekannten Anordnungen im Hochspannungsbereich nicht erreichbar sind. Zu diesem Zweck werden die Varistoren in ein Element mit hoher Begrenzerspannung (15) und ein Element mit niedriger Begrenzerspannung (16) aufgeteilt. Optional ist ein hochohmiger Beschaltungswiderstand (5) einsetzbar um die statische Spannungsaufteilung besser zu definieren, welche andernfalls durch die Kennlinientoleranzen der Varistoren bestimmt würde. Eine sinnvolle Dimensionierung besteht darin, dass die Summe beider Begrenzerspannungen der Varistoren (15, 16) mit einem gewissen Sicherheitsabstand oberhalb der höchsten, dauernden DC-Spannung des Netzes gewählt wird. Diese Bemessungsgrenze ist von anderen Varistor-Begrenzern her bekannt und muss eingehalten werden um hohe statische Energieverluste zu vermeiden. Die resultierende dynamische Begrenzerspannung (unter hohem Impulsstrom) ist dann unerwünscht hoch (typ. um ca. Faktor 2 überhöht), weil die Kennlinien realer Varistoren nicht ideal steil sind.

Als weiterer Freiheitsgrad in der erfindungsgemäßen Anordnung ist jedoch der Quotient der beiden Begrenzerspannungen wählbar. Dieser wird - abhängig von den genauen Varistor-Kennlinien - typischerweise so gewählt, dass die Begrenzerspannung (U15) des Elementes (15) ca. das 3-fache bis 5-fache der des Elements (16) beträgt. Im stationären Fall liegt resultierend näherungsweise die Begrenzerspannung des Elements (16) als positive Vorladespannung (UC) an dem kapazitiven Energiespeicher (10). Durch Zündung des Thyristors (11) ist es nun möglich, diese Spannung umzupolen, so dass sich die Begrenzerspannung der gesamten Anordnung momentan um den doppelten Betrag der o.a. Vorladespannung reduziert. Die reduzierte Begrenzerspannung ermöglicht nun eine wesentlich bessere, dynamische Überspannungsbegrenzung. Der einsetzende Begrenzerstrom führt nachfolgend zu einer Aufladung des kapazitiven Energiespeichers (10) auf die vorher anliegende, positive Vorladespannung, welche stationär erwünscht ist. Die Zündung des Thyristors kann synchron mit der des Stromimpulsgenerators erfolgen. Es ist des weiteren vorteilhaft, dass die gleichen Komponenten (9, 10, 11) wie im Stromimpulsgenerator verwendet werden können. Da der Überspannungsbegrenzer in den erfindungsgemäßen Schaltungsanordnungen für mehrere Schalter mehrfach genutzt werden kann, wird der Aufwand für eine optimierte Ausführung nach Fig. 18 in vielen Anwendungen lohnend sein.

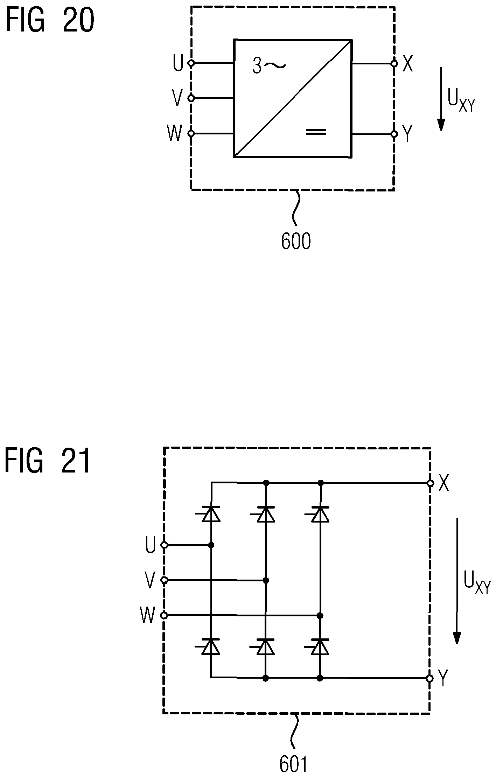

Ein weiteres Problem ausgedehnter, vermaschter DC-Netze besteht bezüglich der Stromaufteilung in elektrisch parallelen Leitungsabschnitten. Weil sich diese in nicht steuerbarer Weise durch die ohmschen Spannungsabfälle einstellt, ist eine definierte Grenzbelastung und gute Ausnutzung der Leitungen - ohne Überlastung - nicht sicherzustellen. Bei den erfindungsgemäßen Hybridschaltern (100) bietet sich als aufwandsarme Lösung für diese Steuerbarkeit der Stromaufteilung die folgende Maßnahme an (Figur 20 und Figur 21):

Eine steuerbare DC-Spannungsquelle (600) mit einer , verglichen mit dem DC-Netz , kleinen Spannung und Leistung , wird mit ihren Ausgangsklemmen (X,Y) parallel zu einem Hybridschalter (100) angeschlossen.

Dabei ist die Polarität der angelegten Spannung so zu wählen, dass sie der Sperrrichtung des ungesteuerten Elementes (12), beziehungsweise der entsprechenden Halbleiterdiode , entspricht. Durch diese Anordnung lässt sich deren natürlicher Durchlass-Spannungsabfall von positiven Werten kontinuierlich auf negative Werte steuern und somit die Stromverteilung in gewünschter Weise beeinflussen. Diese Funktion kann jederzeit durch Öffnen des parallelen, gesteuerten Schalters (18) aktiviert und durch ein Schließen dieses Schalters deaktiviert werden.

Ein einfacher, netzgeführter Stromrichter (601) mit nur einer ausgangsseitigen Strom- und Spannungs-Polarität kann die Funktion der DC-Spannungsquelle (600) übernehmen, die grundsätzlich an jedem Hybridschalter (100) hinzugefügt werden kann. Im allgemeinen wird es jedoch ausreichend sein, nur einen oder wenige der Hybridschalter zu beschalten. Für Hybridschalter (100) hoher Spannung, welche aus einer Reihenschaltung mehrerer Hybridschalter bestehen, ist es vorteilhaft die DC-Spannungsquelle (600) nur an einem der seriengeschalteten Elemente anzuschließen. Auf diese Weise lässt sich vermeiden, dass die Spannungsquelle (600) ausgangseitig für unnötig hohe Spannungen sperrfähig sein muss.

## Patentansprüche

1. Vorrichtung zum Schalten in einem Gleichspannungsnetz mit

- zwei gegensinnig in Reihe geschalteten Hybridschaltern (100), welche jeweils eine Parallelschaltung eines ungesteuerten stromrichtungsabhängigen Schalters (12) und eines steuerbaren Schalters (18) aufweisen, wobei der innere Verbindungspunkt zwischen den Hybridschaltern einen dritten Anschluss ausbildet und die zwei gegensinnig in Reihe geschalteten Hybridschalter (100) mit einem ersten und einem zweiten Anschluss in eine erste Leitung des Gleichspannungsnetzes einfügbar sind;
**gekennzeichnet durch**
- zwei polarisierte Dämpfungsglieder (200), die zur Energieaufnahme in nur einer Polarität der anliegenden Klemmenspannung eingerichtet sind, wobei das erste polarisierte Dämpfungsglied (200) an den ersten Anschluss der in Reihe geschalteten Hybridschalter angeschlossen ist und mit einer zweiten Leitung des Gleichspannungsnetzes und/oder einem Erdpotential verbindbar ist und das zweite polarisierte Dämpfungsglied (200) an den zweiten Anschluss der in Reihe geschalteten Hybridschalter (100) angeschlossen ist und mit der zweiten Leitung des Gleichspannungsnetzes und/oder dem Erdpotential verbindbar ist; und
- einen Stromimpulsgenerator (300), der - auf einen Steuerbefehl hin - zum Erzeugen eines über den dritten Anschluss und die polarisierten Dämpfungsglieder (200) führenden unipolaren Stromimpulses eingerichtet ist, so dass die Stromrichtung in einem der Hybridschalter (100) kurzzeitig umkehrbar ist.

2. Vorrichtung nach Anspruch 1,
wobei wenigstens ein weiteres Paar gegensinnig zueinander in Reihe geschalteter Hybridschalter vorgesehen ist, zwischen denen ein Verbindungspunkt als dritter Anschluss ausgebildet ist, und die mit ihrem ersten und zweiten Anschluss in wenigstens eine weitere Leitung des Gleichspannungsnetzes schaltbar sind, wobei weitere Dämpfungsglieder (200) vorgesehen sind, und wobei der Verbindungspunkt jeden Paares von gegensinnig zueinander in Reihe geschalteter Hybridschaltern über eine Sperrdiode (2) mit dem Stromimpulsgenerator verbunden ist.

3. Vorrichtung nach Anspruch 2,
wobei dem weiteren Paar von Hybridschaltern (100) ein weiteres Paar polarisierter Dämpfungsglieder (200) zugeordnet ist.

4. Vorrichtung nach Anspruch 1,
wobei zwei weitere gegensinnig in Reihe geschaltete Hybridschalter (100) mit ihrem ersten und zweiten Anschluss in die zweite Leitung des Gleichspannungsnetzes einfügbar sind, wobei das erste polarisierte Dämpfungsglied mit dem ersten Anschluss der ersten Reihenschaltung von Hybridschaltern und mit dem ersten Anschluss der zweiten Reihenschaltung von Hybridschaltern verbunden ist und das zweite polarisierte Dämpfungsglied mit dem zweiten Anschluss der ersten Reihenschaltung von Hybridschaltern und mit dem zweiten Anschluss der zweiten Reihenschaltung von Hybridschaltern verbunden ist und wobei der erste Anschluss des Stromimpulsgenerators (300) mit dem mittleren Verbindungspunkt der ersten Reihenschaltung von Hybridschaltern verbunden ist und der zweite Anschluss des Stromimpulsgenerators mit dem mittleren Verbindungspunkt der zweiten Reihenschaltung von Hybridschaltern verbunden ist.

5. Vorrichtung nach einem der vorhergehenden Ansprüche,
wobei die polarisierten Dämpfungsglieder (200) und / oder der Stromimpulsgenerator (300) aus einer Reihenschaltung jeweils mehrerer dieser Elemente bestehen, so dass sie Mittelanzapfungen aufweisen, von denen eine, mehrere oder alle mit dem Erdpotential verbunden sind.

6. Vorrichtung nach einem der vorhergehenden Ansprüche,
wobei zwei weitere gegensinnig in Reihe geschaltete Hybridschalter und zwei weitere polarisierte Dämpfungsglieder vorgesehen sind und der dritte Anschluss der zwei weiteren in Reihe geschalteten Hybridschalter mit dem dritten Anschluss der zwei in Reihe geschalteten Hybridschalter in der ersten Leitung verbindbar ist, so dass der Strompuls des Stromimpulsgenerators auch in den dritten Anschluss der zwei weiteren in Reihe geschalteten Hybridschalter einspeisbar ist.

7. Vorrichtung nach einem der vorhergehenden Ansprüche,
wobei parallel zu einem oder mehreren der Hybridschalter (100) eine zusätzliche steuerbare DC-Spannungsquelle (600) parallel geschaltet ist, deren Spannung eine dem natürlichen Durchlass-Spannungsabfall des ungesteuerten stromrichtungsabhängigen Schalters (12) entgegengesetzte Polarität aufweist.

8. Vorrichtung nach einem der vorhergehenden Ansprüche,
wobei der ungesteuerte stromrichtungsabhängige Schalter (12) eine Halbleiterdiode ist.

9. Vorrichtung nach einem der vorhergehenden Ansprüche,
wobei der steuerbare Schalter (18) eine Vakuumschaltröhre ist.

10. Vorrichtung nach einem der vorhergehenden Ansprüche,
wobei der Stromimpulsgenerator (300) mindestens einen kapazitiven Energiespeicher (10) und eine Induktivität (9) enthält, die über einen steuerbaren Schalter (11) kurzzeitig elektrisch miteinander verbunden werden können , sowie einen Schaltungspfad zur Aufladung des kapazitiven Energiespeichers (10) aus der Spannung des Gleichspannungsnetzes und zur Überspannungsbegrenzung, welcher mindestens diesen Energiespeicher (10), einen Reihenwiderstand (13) und eine Sperrdiode (2) enthält.

11. Vorrichtung nach einem der vorhergehenden Ansprüche,
wobei dem Stromimpulsgenerator (300) zusätzliche Elemente zur Überspannungsbegrenzung parallel geschaltet oder in diesen integriert sind.

12. Vorrichtung nach Anspruch 10,
wobei die zusätzlichen Elemente zur Überspannungsbegrenzung nichtlineare Widerstände, insbesondere Varistoren, sind.

13. Vorrichtung nach Anspruch 11 oder 12,
wobei der Spannungspegel der Überspannungsbegrenzung synchronisiert mit der Auslösung des Stromimpulses des Stromimpulsgenerators (300) dynamisch anpassbar ist.

14. Verfahren zum Schalten in einem Gleichspannungsnetz mit

- zwei gegensinnig in Reihe geschalteten Hybridschaltern (100), welche jeweils eine Parallelschaltung eines ungesteuerten stromrichtungsabhängigen Schalters (12) und eines steuerbaren Schalters (18) aufweisen, wobei der innere Verbindungspunkt zwischen den Hybridschaltern einen dritten Anschluss ausbildet und die zwei gegensinnig in Reihe geschalteten Hybridschalter (100) mit einem ersten und einem zweiten Anschluss in eine erste Leitung des Gleichspannungsnetzes einfügbar sind; und
- zwei polarisierten Dämpfungsgliedern (200), die zur Energieaufnahme in nur einer Polarität der anliegenden Klemmenspannung eingerichtet sind, wobei das erste polarisierte Dämpfungsglied (200) an den ersten Anschluss der in Reihe geschalteten Hybridschalter angeschlossen ist und mit einer zweiten Leitung des Gleichspannungsnetzes und/oder einem Erdpotential verbindbar ist und das zweite polarisierte Dämpfungsglied (200) an den zweiten Anschluss der in Reihe geschalteten Hybridschalter (100) angeschlossen ist und mit der zweiten Leitung des Gleichspannungsnetzes und/oder dem Erdpotential verbindbar ist; wobei bei dem Verfahren
- von einem Stromimpulsgenerator (300) - auf einen Steuerbefehl hin - ein über den dritten Anschluss und die polarisierten Dämpfungsglieder (200) führender unipolarer Stromimpuls erzeugt wird, so dass die Stromrichtung in einem der Hybridschalter (100) kurzzeitig umgekehrt wird, so dass der steuerbare Schalter des Hybridschalters während der Stromumkehr verlöschen kann und so die Stromzufuhr zwischen einer Quelle und einem Verbraucher getrennt wird.

**Claims**

1. Device for switching in a DC voltage grid comprising

- two hybrid switches (100) connected in series in opposite directions, said hybrid switches each having a parallel circuit comprising an uncontrolled current-direction-dependent switch (12) and a controllable switch (18), wherein the internal junction point between the hybrid switches forms a third connection and the two hybrid switches (100) connected in series in opposite directions can be inserted by a first and a second connection into a first line of the DC voltage grid; **characterized by**
- two polarized damping elements (200), which are designed to absorb energy in only one polarity of the terminal voltage present, wherein the first polarized damping element (200) is connected to the first connection of the series-connected hybrid switches and can be connected to a second line of the DC voltage grid and/or a ground potential and the second polarized damping element (200) is connected to the second connection of the series-connected hybrid switches (100) and can be connected to the second line of the DC voltage grid and/or the ground potential; and
- a current pulse generator (300), which - in response to a control command - is designed to generate a unipolar current pulse passing via the third connection and the polarized damping elements (200), such that the current direction in one of the hybrid switches (100) can be momentarily reversed.

2. Device according to Claim 1,
wherein at least one further pair of hybrid switches connected in series with one another in opposite directions is provided, between which hybrid switches a junction point is formed as a third connection, and which hybrid switches can be switched into at least one further line of the DC voltage grid by their first and second connections, wherein further damping elements (200) are provided, and wherein the junction point of each pair of hybrid switches connected in series with one another in opposite directions is connected to the current pulse generator via a blocking diode (2).

3. Device according to Claim 2,
wherein a further pair of polarized damping elements (200) is assigned to the further pair of hybrid switches (100).

4. Device according to Claim 1,
wherein two further hybrid switches (100) connected in series in opposite directions can be inserted by their first and second connections into the second line of the DC voltage grid, wherein the first polarized damping element is connected to the first connection of the first series circuit of hybrid switches and to the first connection of the second series circuit of hybrid switches and the second polarized damping element is connected to the second connection of the first series circuit of hybrid switches and to the second connection of the second series circuit of hybrid switches, and wherein the first connection of the current pulse generator (300) is connected to the central junction point of the first series circuit of hybrid switches and the second connection of the current pulse generator is connected to the central junction point of the second series circuit of hybrid switches.

5. Device according to any of the preceding claims,
wherein the polarized damping elements (200) and/or the current pulse generator (300) consist(s) of a series circuit comprising in each case a plurality of these units, such that they have center taps, one, a plurality or all of which are connected to the ground potential.

6. Device according to any of the preceding claims,
wherein two further hybrid switches connected in series in opposite directions and two further polarized damping elements are provided and the third connection of the two further series-connected hybrid switches can be connected to the third connection of the two series-connected hybrid switches in the first line, such that the current pulse of the current pulse generator can also be fed into the third connection of the two further series-connected hybrid switches.

7. Device according to any of the preceding claims,
wherein an additional controllable DC voltage source (600) is connected in parallel with one or a plurality of the hybrid switches (100), the voltage of said DC voltage source having a polarity opposite to the natural forward voltage drop of the uncontrolled current-direction-dependent switch (12).

8. Device according to any of the preceding claims,
wherein the uncontrolled current-direction-dependent switch (12) is a semiconductor diode.

9. Device according to any of the preceding claims,
wherein the controllable switch (18) is a vacuum interrupter.

10. Device according to any of the preceding claims,
wherein the current pulse generator (300) contains at least one capacitive energy store (10) and an inductance (9), which can be momentarily electrically connected to one another via a controllable switch (11), and also a circuit path for charging the capacitive energy store (10) from the voltage of the DC voltage grid and for overvoltage limiting, said circuit path containing at least said energy store (10), a series resistor (13) and a blocking diode (2).

11. Device according to any of the preceding claims,
wherein additional units for overvoltage limiting are connected in parallel with the current pulse generator (300) or are integrated into the latter.

12. Device according to Claim 10,
wherein the additional units for overvoltage limiting are nonlinear resistors, in particular varistors.

13. Device according to Claim 11 or 12,
wherein the voltage level of the overvoltage limiting can be dynamically adapted in a manner synchronized with the initiation of the current pulse of the current pulse generator (300).

14. Method for switching in a DC voltage grid comprising

- two hybrid switches (100) connected in series in opposite directions, said hybrid switches each having a parallel circuit comprising an uncontrolled current-direction-dependent switch (12) and a controllable switch (18), wherein the internal junction point between the hybrid switches forms a third connection and the two hybrid switches (100) connected in series in opposite directions can be inserted by a first and a second connection into a first line of the DC voltage grid; and

- two polarized damping elements (200), which are designed to absorb energy in only one polarity of the terminal voltage present, wherein the first polarized damping element (200) is connected to the first connection of the series-connected hybrid switches and can be connected to a second line of the DC voltage grid and/or a ground potential and the second polarized damping element (200) is connected to the second connection of the series-connected hybrid switches (100) and can be connected to the second line of the DC voltage grid and/or the ground potential; and wherein in the method

- there is generated by a current pulse generator (300) - in response to a control command - a unipolar current pulse passing via the third connection and the polarized damping elements (200), such that the current direction in one of the hybrid switches (100) is momentarily reversed, such that the controllable switch of the hybrid switch can quench during the current reversal and thus the current feed between a source and a load is isolated.

## Revendications

1. Système de connexion dans un réseau à tension continue, comprenant

- deux interrupteurs (100) hybrides, qui sont montés en série en sens contraire et qui ont chacun un circuit en parallèle d'un interrupteur (12) dépendant du sens du courant et non-commandé et d'un interrupteur (18) pouvant être commandé, le point de liaison intérieure entre les interrupteurs hybrides, constituant une troisième borne, et les deux interrupteurs (100) hybrides, montés en série en sens contraire, pouvant être, par une première et une deuxième bornes, insérés dans une première ligne du réseau à tension continue ;
**caractérisé par**
- deux éléments (200) polarisés d'amortissement, qui sont conçus pour n'absorber de l'énergie que dans une polarité de la tension appliquée aux bornes, le premier élément (200) polarisé d'amortissement étant connecté à la première borne des interrupteurs hybrides montés en série et pouvant être relié à une deuxième ligne du réseau à tension continue et/ou à un potentiel de terre et le deuxième élément (200) polarisé d'amortissement étant connecté à la deuxième borne des interrupteurs (100) hybrides montés en série et pouvant être relié à la deuxième ligne du réseau à tension continue et/ou au potentiel de terre et
- un générateur (300) d'impulsions de courant, qui - sur une instruction de commande - est conçu pour produire une impulsion de courant unipolaire passant par la troisième borne et par les éléments (200) polarisés d'amortissement, de manière à pouvoir inverser brièvement le sens du courant dans l'un des interrupteurs (100) hybrides.

2. Système suivant la revendication 1,

dans lequel il est prévu au moins une autre paire d'interrupteurs hybrides, montés en série en sens contraire l'un de l'autre, entre lesquels un point de liaison est formé comme troisième borne, et qui peuvent être connectés par leurs première et deuxième bornes à au moins une autre ligne du réseau à tension continue, dans lequel il est prévu d'autres éléments (200) d'amortissement et dans lequel le point de liaison de chaque paire d'interrupteurs hybrides montés en série et en sens contraire l'un de l'autre est relié au générateur d'impulsions de courant par une diode (2) d'arrêt.

3. Système suivant la revendication 2,
dans lequel une autre paire d'éléments (200) polarisés d'amortissement est associée à l'autre paire d'interrupteurs (100) hybrides.

4. Système suivant la revendication 1,
dans lequel deux autres interrupteurs (100) hybrides montés en série en sens contraire peuvent, par leurs première et deuxième bornes, être insérés dans la deuxième ligne du réseau à tension continue, le premier élément polarisé d'amortissement étant relié à la première borne du premier circuit en série d'interrupteurs hybrides et à la première borne du deuxième circuit en série d'interrupteurs hybrides et l'autre élément polarisé d'amortissement étant relié à la deuxième borne du premier circuit en série d'interrupteurs hybrides et à la deuxième borne du deuxième circuit en série d'interrupteurs hybrides et la première borne du générateur (300) d'impulsions de courant étant reliée au point de liaison médian du premier circuit en série d'interrupteurs hybrides et la deuxième borne du générateur d'impulsions de courant étant reliée au point de liaison médian du deuxième circuit en série d'interrupteurs hybrides.

5. Système suivant l'une des revendications précédentes,
dans lequel les éléments (200) polarisés d'amortissement et/ou le générateur (300) d'impulsions de courant sont constitués d'un circuit en série, respectivement de plusieurs de leurs éléments, de manière à avoir des prises médianes, dont l'une, plusieurs ou toutes sont reliées au potentiel de terre.

6. Système suivant l'une des revendications précédentes,
dans lequel il est prévu deux autres interrupteurs hybrides montés en série en sens contraire et deux autres éléments polarisés d'amortissement et la troisième borne des deux autres interrupteurs hybrides montés en série peut être reliée à la troisième borne des deux interrupteurs hybrides montés en série dans la première ligne, de manière à pouvoir injecter l'impulsion de courant du générateur d'impulsions de courant, également dans la troisième borne des deux autres interrupteurs hybrides montés en série.

7. Système suivant l'une des revendications précédentes,
   dans lequel il est monté, en parallèle à l'un ou à plusieurs des interrupteurs (100) hybrides, une source (600) de tension en courant continu supplémentaire pouvant être commandée, dont la tension a une polarité opposée à la chute de tension directe naturelle de l'interrupteur (12) dépendant du sens du courant et non-commandé.

8. Système suivant l'une des revendications précédentes,
   dans lequel l'interrupteur (12) indépendant du sens du courant et non-commandé est une diode à semi-conducteur.

9. Système suivant l'une des revendications précédentes,
   dans lequel l'interrupteur (18) pouvant être commandé est un tube de commutation à vide.

10. Système suivant l'une des revendications précédentes,
    dans lequel le générateur (300) d'impulsions de courant comporte au moins un accumulateur (10) d'énergie capacitif et une inductance (9), qui peuvent être reliés électriquement entre eux brièvement, par un interrupteur (11) pouvant être commandé, ainsi qu'un trajet de circuit pour charger l'accumulateur (10) d'énergie capacitif à partir de la tension du réseau à tension continue et pour limiter les surtensions, trajet qui comporte au moins cet accumulateur (10) d'énergie, une résistance (13) série et une diode (2) d'arrêt.

11. Système suivant l'une des revendications précédentes,
    dans lequel des éléments supplémentaires de limitation de la surtension sont montés en parallèle au générateur (300) d'impulsions de courant ou y sont intégrés.

12. Système suivant la revendication 10,
    dans lequel les éléments supplémentaires de limitation de la surtension sont des résistances non-linéaires, notamment des varistances.

13. Système suivant la revendication 11 ou 12,
    dans lequel le niveau de tension de la limitation de surtension peut être adapté dynamiquement, en étant synchronisé avec le déclenchement de l'impulsion de courant du générateur (300) d'impulsions de courant.

14. Procédé de connexion dans un réseau à tension continue, comprenant

- deux interrupteurs (100) hybrides, qui sont montés en série en sens contraire et qui ont chacun un circuit en parallèle d'un interrupteur (12) dépendant du sens du courant et non-commandé et d'un interrupteur (18) pouvant être commandé, le point de liaison intérieure entre les interrupteurs hybrides, constituant une troisième borne, et les deux interrupteurs (100) hybrides, montés en série en sens contraire, pouvant être, par une première et une deuxième bornes, insérés dans une première ligne du réseau à tension continue et

- deux éléments (200) polarisés d'amortissement, qui sont conçus pour n'absorber de l'énergie que dans une polarité de la tension appliquée aux bornes, le premier élément (200) polarisé d'amortissement étant connecté à la première borne des interrupteurs hybrides montés en série et pouvant être relié à une deuxième ligne du réseau à tension continue et/ou à un potentiel de terre et le deuxième élément (200) polarisé d'amortissement étant connecté à la deuxième borne des interrupteurs (100) hybrides montés en série et pouvant être relié à la deuxième ligne du réseau à tension continue et/ou au potentiel de terre ; dans lequel dans le procédé

- on produit par un générateur (3) d'impulsions de courant - sur une instruction de commande - une impulsion de courant unipolaire passant par la troisième borne et par les éléments (200) polarisés d'amortissement, de manière à inverser brièvement le sens du courant dans l'un des interrupteurs (100) hybrides, de manière à pouvoir, pendant l'inversion du courant, désamorcer l'interrupteur pouvant être commandé de l'interrupteur hybride et ainsi couper l'envoi de courant entre une source et un consommateur.

FIG 1 (Stand der Technik)

FIG 2 (Stand der Technik)

FIG 3 (Stand der Technik)

FIG 4

$P_1$ $\quad$ $i_1$ $\quad$ 7 $\quad$ $i_{11}$ $\quad$ $P_{11}$

$N_0$ $\quad\quad\quad\quad\quad\quad\quad\quad\quad\quad$ $N_0$

FIG 5

7

$P_1$

$P_2$ $\quad\quad\quad\quad\quad\quad\quad\quad\quad$ $P_S$

7

$N_0$ $\quad\quad\quad\quad\quad\quad\quad\quad\quad\quad$ $N_0$

## FIG 6

$P_1$ ○→ $i_1$  —— 7 —— $i_{11}$ →○ $P_{11}$

$N_0$ ○———————○ $N_0$

$P_0$ ○———————○ $P_0$

$N_2$ ○← $i_2$ —— 7 —— $i_{21}$ ←○ $N_{21}$

## FIG 7

$P_1$ ○→ $i_1$  —— 7 —— $i_{11}$ →○ $P_{11}$

$U_{P1E}$ ↓     $U_{P11E}$ ↓

$U_{N2E}$ ↓     $U_{N21E}$ ↓

$N_2$ ○← $i_2$ —— 7 —— $i_{21}$ ←○ $N_{21}$

FIG 8

FIG 9

FIG 10

FIG 11

FIG 12

FIG 13

FIG 14

FIG 15

FIG 16

FIG 17

FIG 18

FIG 19

FIG 20

$U_{XY}$

600

FIG 21

$U_{XY}$

601

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10103031 A1
- WO 2008067786 A
- US 005999388 A
- DE 2311744 A1